# FASCICULE DE BREVET EUROPEEN

(11) **EP 3 066 228 B1**
(45) Date de publication et mention de la délivrance du brevet: **27.02.2019**
(21) Numéro de dépôt: 14809464.2
(22) Date de dépôt: 05.11.2014
(51) Int. Cl.: C23C 14/08, C23C 14/58, C23C 14/02, C03C 17/245, C03C 17/34

(54) **PROCEDE D'OBTENTION D'UN MATERIAU PHOTOCATALYTIQUE**
VERFAHREN ZUR HERSTELLUNG EINES PHOTOKATALYSATORMATERIALS
METHOD FOR OBTAINING A PHOTOCATALYTIC MATERIAL

(30) Priorité: 07.11.2013 FR 1360921
(43) Date de publication de la demande: 14.09.2016
(73) Titulaire: Saint-Gobain Glass France, 92400 Courbevoie (FR)
(72) Inventeur: MAILLET, Alexandre, F-60200 Compiègne (FR); MAGNE, Constance, F-75019 Paris (FR)
(74) Mandataire: Saint-Gobain Recherche
(86) Numéro de dépôt international: PCT/FR2014/052819
(87) Numéro de publication internationale: WO 2015/067893

(56) Documents cités:
- WO-A1-2005/021456
- WO-A1-2010/031808
- WO-A1-2011/110584
- FR-A1- 2 929 938

## Description

L'invention se rapporte au domaine des couches minces inorganiques à base d'oxyde de titane, notamment déposées sur des substrats en verre. Elle concerne plus particulièrement un procédé d'obtention d'un matériau autonettoyant comprenant une couche mince à base d'oxyde de titane cristallisé.

De nombreuses couches minces sont déposées sur des substrats, notamment en verre plat ou faiblement bombé, afin de conférer aux matériaux obtenus des propriétés particulières : propriétés optiques, par exemple de réflexion ou d'absorption de rayonnements d'un domaine de longueurs d'onde données, propriétés de conduction électrique particulière, ou encore propriétés liées à la facilité de nettoyage ou à la possibilité pour le matériau de s'auto-nettoyer.

Ces couches minces sont le plus souvent à base de composés inorganiques : oxydes, nitrures, ou encore métaux. Leur épaisseur varie généralement de quelques nanomètres à quelques centaines de nanomètres, d'où leur qualificatif de « minces ».

Les couches minces à base d'oxyde de titane ont la particularité d'être autonettoyantes, en facilitant la dégradation des composés organiques sous l'action de rayonnements ultraviolets et l'élimination des salissures minérales (poussières) sous l'action d'un ruissellement d'eau.

Ces couches présentent la particularité de voir certaines de leurs propriétés améliorées lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X), voire dans certains cas à favoriser une forme cristallographique particulière.

Il est connu que l'oxyde de titane cristallisé sous la forme anatase est bien plus efficace en terme de dégradation des composés organiques que l'oxyde de titane amorphe ou cristallisé sous la forme rutile ou brookite.

Un procédé couramment employé à l'échelle industrielle pour le dépôt de couches minces, notamment sur substrat verrier, est le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. Il est ainsi connu de déposer, par procédé magnétron du type réactif, des couches d'oxyde de titane en employant une cible en titane métallique ou une cible céramique en TiOₓ (avec x < 2) et un gaz plasmagène à base d'oxygène. L'avantage majeur de ce procédé réside dans la possibilité de déposer sur une même ligne un empilement très complexe de couches en faisant successivement défiler le substrat sous différentes cibles, ce généralement dans un seul et même dispositif.

Lors de la mise en oeuvre industrielle du procédé magnétron, le substrat reste à température ambiante ou subit une élévation de température modérée (moins de 80°C), particulièrement lorsque la vitesse de défilement du substrat est élevée (ce qui est généralement recherché pour des raisons économiques). Ce qui peut paraître un avantage constitue toutefois un inconvénient dans le cas des couches précitées, car les faibles températures impliquées ne permettent généralement pas une croissance cristalline suffisante. C'est le cas tout particulièrement pour des couches minces de faible épaisseur et/ou des couches constituées de matériaux dont le point de fusion est très élevé. Les couches obtenues selon ce procédé sont donc majoritairement voire totalement amorphes ou nano-cristallisées (la taille moyenne des grains cristallins étant inférieure à quelques nanomètres), et des traitements thermiques se révèlent nécessaires pour obtenir le taux de cristallisation souhaité ou la taille de grains désirée.

Des traitements thermiques possibles consistent à réchauffer le substrat soit pendant le dépôt, soit à l'issue du dépôt, en sortie de ligne magnétron.

La demande WO 2009/136110 divulgue un procédé de cristallisation d'une couche mince d'oxyde de titane déposée sur un substrat. Lors de ce procédé, la face du substrat opposée à la face portant la couche mince à cristalliser n'est pas chauffée à une température supérieure à 150°C. Cette caractéristique est obtenue en choisissant un mode de chauffage spécialement adapté au chauffage de la couche mince. L'objectif est de ne pas avoir à réaliser des traitements à température élevée.

Les demandes WO 2011/110584 et WO 2010/031808 divulguent un procédé d'obtention d'un matériau comprenant un substrat et au moins une couche mince d'oxyde mixte de titane et, par exemple d'oxyde de zirconium, déposée sur une face dudit substrat, ledit procédé comprenant la déposition de ladite couche mince d'oxyde mixte, suivie de celle d'une couche de protection temporaire inorganique à base de carbone, et d'un traitement thermique à température élevée.

L'invention concerne spécifiquement des matériaux soumis à un traitement à température élevée de type trempe, recuit et/ou bombage. Selon l'invention, on entend par traitement à température élevée, un traitement pendant lequel le substrat est chauffé à une température supérieure à 350 °C, de préférence supérieure à 400 °C, voire supérieure à 500 °C. Cette température élevée correspond dans le cas d'un substrat en verre à une température supérieure à la température de ramollissement.

De tels traitements thermiques devraient conduire normalement à l'obtention d'une couche mince d'oxyde de titane présentant une cristallisation satisfaisante en terme de taux de cristallisation, taille de grains et forme cristallographique. Le pouvoir autonettoyant dépend directement de la qualité de cristallisation de la couche mince d'oxyde de titane

Cependant, on constate des différences importantes concernant le pouvoir autonettoyant des matériaux soumis à des traitements thermiques à température élevée. Le pouvoir autonettoyant est plus faible que celui escompté. Les causes pouvant expliquer ces différences sont nombreuses.

Les traitements thermiques sont en général réalisés sur des lieux autres que celui où est déposée la couche mince sur le substrat. Les substrats revêtus subissent donc des étapes de stockage et de transport lors desquelles une pollution chimique ou des altérations mécaniques peuvent se produire. Mais surtout, ils existent des variations importantes quant aux traitements thermiques notamment concernant les températures maximales, les rampes de montée en température, les durées de traitements et l'environnement dans lequel est réalisé ledit traitement.

Dans la mesure où il n'est pas possible de contrôler l'ensemble des conditions des traitements thermiques, il s'avère alors nécessaire de proposer un procédé permettant d'obtenir un matériau qui acquiert des propriétés autonettoyantes grâce à un traitement thermique à température élevée mais dont le pouvoir autonettoyant est élevé et indépendant des variations pouvant exister entre lesdits traitements thermiques.

A cet effet, l'invention a pour objet un procédé d'obtention d'un matériau comprenant un substrat et au moins une couche mince à base d'oxyde de titane et déposée sur une première face dudit substrat, ledit procédé comprenant les étapes suivantes :
- on dépose ladite au moins une couche mince à base d'oxyde de titane,
- on dépose au-dessus de ladite couche mince à base d'oxyde de titane, une couche de protection temporaire inorganique à base de carbone,
- on soumet le matériau à un traitement thermique à une température supérieure à 350 °C, de préférence 400 °C.

La couche de protection temporaire est déposée au-dessus de la couche mince à base d'oxyde de titane. Il s'agit dans ce cas d'une surcouche. Cette couche de protection temporaire est éliminée au moins partiellement, de préférence totalement lors du traitement thermique.

Le traitement thermique consiste de préférence en une trempe, un recuit dit longue durée (« heat soak ») ou un bombage.

L'invention repose sur la présence d'une surcouche inorganique à base de carbone qui permet un chauffage local plus efficace d'une couche d'oxyde de titane pendant un traitement thermique à température élevée, et ce peu importe les conditions du traitement thermique. L'effet positif est attribuable aux propriétés absorbantes de ladite couche de protection temporaire et à la protection de la couche d'oxyde de titane de l'atmosphère ambiant (oxygène, éventuels polluants). L'énergie finale apportée à la couche d'oxyde de titane pour favoriser une cristallisation homogène est supérieure à celle apportée par le seul traitement thermique de l'oxyde de titane grâce à des phénomènes d'absorption, de création d'énergie et de transfert de l'énergie absorbée et/ou créée.

Les couches de protection temporaire sont qualifiées de temporaire, au sens où, après avoir jouées leur rôle de pourvoyeuse d'énergie au profit de l'oxyde de titane, elles ne font plus partie en tant que telles (sous leur forme initiale) du matériau final.

La présence de cette couche temporaire diminue de la transmission lumineuse. Cependant, la couche de protection temporaire s'oxyde au moins partiellement, voire totalement, lors du traitement thermique, et devient au moins partiellement transparente dans le domaine du visible. La transmission lumineuse augmente après élimination de cette couche lors du traitement thermique.

Le matériau obtenu selon le procédé de l'invention présente un pouvoir autonettoyant élevé se traduisant par de bonnes propriétés photocatalytiques et superhydrophiles, propriétés obtenues systématiquement selon le type de traitement thermique choisi.

La couche de protection temporaire présente pour avantage supplémentaire de protéger le substrat revêtu lors de toutes les étapes précédant le traitement thermique et notamment de limiter les rayures et défauts pouvant être créés lors des étapes de stockage, de transport et de transformation telles que la découpe et le façonnage.

Par « déposée sur une première face dudit substrat », on n'entend pas nécessairement que la couche est déposée directement sur le substrat. Elle peut l'être, mais une ou plusieurs sous-couches peuvent être interposées entre le substrat et la couche à base d'oxyde de titane, comme explicité dans la suite du texte.

Le taux de cristallisation obtenu à l'aide du procédé selon l'invention est élevé. Ce taux de cristallisation, défini comme étant la masse de matériau cristallisé sur la masse totale de matériau, peut être évalué par diffraction des rayons X en utilisant la méthode de Rietveld. Du fait d'un mécanisme de cristallisation par croissance de grains cristallins à partir de germes ou nuclei, l'augmentation du taux de cristallisation s'accompagne généralement d'une augmentation de la taille des grains cristallisés ou des domaines cohérents de diffraction mesurés par diffraction des rayons X.

La face du substrat opposée à la face sur laquelle la couche à base d'oxyde de titane est déposée peut être nue ou être recouverte par une ou plusieurs couches minces. Il peut notamment s'agir de couche à base d'oxyde de titane, ou de couches à fonctions thermiques (couches ou empilements de contrôle solaire ou bas-émissifs, notamment du type comprenant au moins une couche d'argent) ou optiques (par exemples couches ou empilements antireflets).

La couche à base d'oxyde de titane est de préférence une couche en oxyde de titane éventuellement dopé par un ion métallique, par exemple un ion d'un métal de transition, ou par des atomes d'azote, de carbone, de fluor.

Après le traitement thermique, l'intégralité de la surface de cette couche est de préférence en contact avec l'extérieur de manière à ce que l'oxyde de titane puisse pleinement jouer sa fonction autonettoyante.

La couche mince à base d'oxyde de titane ou la couche de protection temporaire peut être obtenue par tout type de procédé, en particulier des procédés générant des couches majoritairement amorphes ou nano-cristallisées, tels que le procédé magnétron, le procédé de dépôt chimique en phase vapeur assisté par plasma (PECVD), le procédé d'évaporation sous vide, ou le procédé sol-gel. Elle est toutefois de préférence une couche « sèche », ne contenant pas de solvant aqueux ou organique, en opposition avec une couche « humide », par exemple obtenue par le procédé sol-gel.

La couche mince à base d'oxyde de titane et la couche de protection temporaire sont de préférence déposées par pulvérisation cathodique, notamment assisté par un champ magnétique (procédé magnétron).

La couche de protection temporaire est de préférence déposée en contact direct avec la couche à base d'oxyde de titane, de préférence sur cette dernière. De cette manière, on optimise les transferts d'énergie de la couche de protection temporaire vers la couche à base d'oxyde de titane.

La couche de protection temporaire peut être en carbone amorphe du type graphite et/ou diamant. La couche de protection temporaire est inorganique par opposition à une couche de nature organique comprenant un composé à base de carbone et d'hydrogène.

Le carbone absorbe le rayonnement infrarouge, et sous l'effet du traitement thermique, subit une réaction de combustion. L'énergie dégagée par cette réaction exothermique va contribuer à favoriser la cristallisation de l'oxyde de titane.

La couche de protection temporaire présente de préférence une absorption dans un domaine de longueur d'ondes compris entre 300 et 1000 nm, de préférence entre 400 et 800 nm.

La couche de protection temporaire émet de l'énergie lors de son élimination par réaction exothermique. Cette énergie émise à proximité de, et transférer vers la couche d'oxyde de titane contribue à améliorer sa cristallisation.

La couche de protection temporaire éliminée lors du traitement thermique par réaction exothermique, notamment de combustion ou d'oxydation, se transforme au moins partiellement en gaz. Une élimination totale de la couche de carbone permet d'augmenter la surface de contact de la couche d'oxyde de titane avec l'extérieur et donc la surface active pour la photocatalyse.

La couche de protection temporaire présente une épaisseur comprise entre 1 et 50 nm, de préférence entre 2 et 10 nm, voire entre 2 et 5 nm. Lorsque la couche de protection temporaire a une épaisseur inférieure à 10 nm, son élimination au traitement thermique est totale.

La variation de la transmission lumineuse dans le visible ΔTL induite par la couche de protection temporaire est supérieure à 2 %, voire supérieure à 5 %. La variation est obtenue en mesurant la transmission lumineuse d'un substrat revêtu d'un empilement ne comprenant pas de couche de protection temporaire (TL réf) et d'un même substrat revêtu comprenant la couche temporaire (TL pro) puis en réalisant le calcul suivant : ΔTL = (TL réf - TL pro).

D'une manière générale, toutes les caractéristiques lumineuses présentées dans la présente description sont obtenues selon les principes et méthodes décrits dans la norme européenne EN 410 se rapportant à la détermination des caractéristiques lumineuses et solaires des vitrages utilisés dans le verre pour la construction. De manière conventionnelle, les indices de réfraction sont mesurés à une longueur d'onde de 550 nm. Par T_{L}, on entend au sens de la présente description la transmission à incidence normale, sous l'illuminant D65 avec un champ de vision de 2°.

Une couche de carbone graphite est avantageusement déposée par pulvérisation cathodique assistée par champ magnétique (procédé magnétron) en utilisant une cible en carbone graphite sous atmosphère inerte notamment d'argon. D'autres procédés possibles comprennent le dépôt par source ionique, le dépôt chimique en phase vapeur assisté par plasma (PECVD).

Le traitement thermique se fait de préférence sous air et/ou à pression atmosphérique. La température et la durée du traitement thermique dépendent des propriétés recherchées et des caractéristiques des matériaux. Les paramètres du traitement thermique tels que la puissance des moyens de chauffage ou le temps de chauffage sont à adapter au cas par cas par l'homme du métier en fonction de divers paramètres tels que la nature du procédé de chauffage, les caractéristiques des matériaux et notamment l'épaisseur et la nature du substrat, l'épaisseur et la nature de la couche mince à base d'oxyde de titane et la présence éventuelle de couches autres de type contrôle solaire ou bas émissif.

Le traitement thermique peut être réalisé à une température d'au moins 350 °C, d'au moins 400 °C, d'au moins 500 °C, d'au moins 550 °C, d'au moins 600 °C, voire d'au moins 650 °C.

Le traitement thermique peut notamment être un traitement thermique de type trempe. Le traitement thermique est réalisé à une température d'au moins 500°C, de préférence d'au moins 600 °C, voire d'au moins 650 °C. Le traitement thermique est réalisé pendant une durée d'au moins 30 s, d'au moins 60 s, voire d'au moins 150 s. Par exemple, la trempe est effectuée en chauffant le substrat à environ 685 °C pendant 150 s puis en le refroidissant brusquement.

Le traitement thermique peut également être un recuit dit « longue durée » réalisé à une température comprise entre 350 °C et 550 °C, de préférence entre 400 °C et 500 °C. Ces traitements thermiques peuvent être réalisés pendant une durée d'au moins 1heure, d'au moins 6 heures, voire d'au moins 12 heures.

Selon le procédé de l'invention, on obtient une couche mince à base d'oxyde de titane au moins partiellement cristallisée sous forme anatase.

Le substrat peut être en tout matériau susceptible de résister aux températures élevées du traitement thermique. Le substrat est de préférence transparent, en verre, notamment silico-sodo-calcique. Le substrat peut être incolore ou coloré, par exemple en bleu, vert, bronze ou gris. Il présente avantageusement au moins une dimension supérieure ou égale à 1 m, voire 2 m et même 3 m. L'épaisseur du substrat varie généralement entre 0,5 mm et 19 mm, le procédé selon l'invention étant particulièrement avantageux pour les substrats dont l'épaisseur est inférieure ou égale à 6 mm, voire 4 mm.

Lorsqu'un substrat contenant des ions alcalins (par exemple un verre du type silico-sodo-calcique) est porté à une température élevée, lesdits ions ont tendance à diffuser dans la couche d'oxyde de titane en amoindrissant très sensiblement, voire en annulant, ses propriétés photocatalytiques. Pour cette raison, il est d'usage d'interposer entre la couche mince d'oxyde de titane et le substrat une couche barrière à la migration des alcalins, comme enseigné dans la demande EP-A-0 850 204, ou d'augmenter l'épaisseur de la couche d'oxyde de titane pour qu'au moins l'extrême surface de la couche ne soit pas contaminée, comme enseigné dans la demande EP-A-0 966 409. De préférence, le substrat comprend en outre au moins une couche barrière située entre la couche mince à base de titane et le substrat choisie parmi les couches à base d'oxyde de silicium SiO₂, de SiOC, d'alumine Al₂O₃, de nitrure de silicium Si₃N₄, d'oxyde de zinc et d'étain SnZnOx et d'oxyde de silicium et de zirconium SiZrOx ou de nitrure de silicium et de zirconium SiZrN. De préférence, le matériau comprend au moins une couche barrière à base d'oxyde ou de nitrure de silicium déposée directement au contact de la première face du substrat.

D'autres sous-couches peuvent être insérées entre le substrat et la couche à base d'oxyde de titane. Il peut s'agir de couches ou empilements à fonctions thermiques (couches ou empilements de contrôle solaire ou bas-émissifs, notamment du type comprenant au moins une couche d'argent) ou optiques (par exemples couches ou empilements antireflets notamment du type comprenant au moins une couche de nitrure de niobium).

De préférence, le matériau comprend un empilement antireflet comprenant au moins une couche barrière à base d'oxyde ou de nitrure de silicium déposée directement au contact de la première face du substrat et éventuellement au moins une couche de nitrure de niobium.

L'invention est illustrée à l'aide des exemples de réalisation non limitatifs qui suivent.

### Exemples

Un substrat en verre silico-sodo-calcique obtenu par le procédé float d'épaisseur 4 mm est revêtu de manière connue par le procédé magnétron d'empilements comprenant une couche mince d'oxyde de titane de 10 nm à 12 nm d'épaisseur. Les exemples selon l'invention sont revêtus d'une surcouche en carbone. La couche de carbone est déposée par pulvérisation cathodique assistée par champ magnétique (procédé magnétron) en utilisant une cible en graphite sous atmosphère d'argon.

Dans les tableaux ci-dessous, les épaisseurs sont en nanomètres sauf autres indications.

| **Vitrage 1** | | | |
|---|---|---|---|
| Verre | SiO₂ | TiO₂ | C |
| 4 mm | 20-30 | 10-12 | 2-5 |

| **Vitrage 2** | | | | | | |
|---|---|---|---|---|---|---|
| Verre | SiO₂ | Si₃N₄ | NbN | Si₃N₄ | TiO₂ | C |
| 4 mm | 10-30 | 25-35 | 6-8 | 5-20 | 10-12 | 2-5 |

| **Vitrage 3** | | | | | | | |
|---|---|---|---|---|---|---|---|
| Verre | Si₃N₄ | SiO₂ | ITO | Si₃N₄ | SiO₂ | TiO₂ | C |
| 4 mm | 15-30 | 15-30 | 60-110 | 3-10 | 45-60 | 10-12 | 2-5 |

L'exemple comparatif C2 correspond au vitrage 2 sans couche de protection temporaire.

L'activité photocatalytique est évaluée grâce à une mesure de vitesse de dégradation de bleu de méthylène en présence de rayonnement ultraviolet. Une solution aqueuse de bleu de méthylène est placée en contact dans une cellule étanche avec le substrat revêtu (ce dernier formant le fond de la cellule). Après exposition à un rayonnement ultraviolet pendant 30 minutes, la concentration de bleu de méthylène est évaluée par une mesure de transmission lumineuse. La valeur d'activité photocatalytique (notée Kb et exprimée en g.l⁻¹.min⁻¹), correspond à la diminution de la concentration en bleu de méthylène par unité de temps d'exposition. On considère que l'activité photocatalytique est acceptable si la valeur du Kb est supérieure à 20. On considère que le matériau ne présente pas d'activité photocatalytique si la valeur du Kb est inférieure à 10.

L'activité photocatalytique peut également être évaluée par mesure de la variation du flou ΔH, après deux cycles lors desquels le substrat revêtu est sali, exposé aux UV et rincé à l'eau claire. Le procédé de mesure du ΔH est décrit dans le projet de norme PR NF EN 1096-5 daté de Août 2011 ayant pour titre « Verre dans la construction - Verre à couche - Partie 5 : méthode d'essai et classification des performances autonettoyantes des surfaces de verre à couche ». Plus la variation de flou est faible, meilleures sont les propriétés autonettoyantes. On considère que le matériau est autonettoyant si la variation de flou est inférieure à 1.

Le tableau 1 ci-après résume les valeurs de kb et ΔH illustrant l'activité photocatalytique après traitement thermique de type trempe correspondant à un chauffage à une température de 630°C pendant 9 minutes.

| **Tableau 1** | **C2** | **Vitrage 2a** | **Vitrage 2b** |
|---|---|---|---|
| Puissance cathode carbone kW | 0 | 15 | 20 |
| Epaisseur de carbone (nm) | 0 | ≈ 2-5 | ≈ 2-5 |
| Kb (µg/L/min) | ≈ 16 | ≈ 25 | ≈ 27 |
| ΔH (%) | 0,7 | 0,6 | 0,4 |

L'exemple comparatif C2 ne comporte pas de couche de protection temporaire. Le pouvoir autonettoyant est inférieur à la valeur cible de 20 kb.

Les vitrages 2a et 2b selon l'invention diffèrent par l'épaisseur de couche de protection temporaire. L'épaisseur de la surcouche de protection temporaire est proportionnelle à la puissance de la cible de carbone.

Ces exemples montrent que l'utilisation d'une couche de protection temporaire permet d'améliorer considérablement le pouvoir autonettoyant mais surtout d'obtenir systématiquement, selon le type de traitement thermique choisi, une valeur supérieure à la valeur cible.

En outre, le carbone s'oxyde en grande partie, puisque la transmission lumineuse après traitement est presque aussi élevée qu'avant dépôt de la surcouche.

La surcouche de carbone est complétement éliminée lors de la trempe. Le produit n'est donc plus absorbant. Il a été vérifié qu'il n'y a pas de diffusion de carbone dans la couche d'oxyde de titane, ni d'impact sur sa morphologie. Ceci laisse penser que l'on ne doit pas impacter les propriétés chimiques et climatiques des vitrages qui doivent résister aux exigences class A selon l'EN 1096-2 pour la face 1.

Le tableau 2 ci-après résume les valeurs de kb illustrant l'activité photocatalytique après traitement thermique de type recuit longue durée correspondant à un chauffage à une température de 450°C pendant 13 heures.

| **Tableau 2** | **C2** | **Vitrage 2a** |
|---|---|---|
| Kb (µg/L/min) | ≈ 30 | ≈ 34 |

On observe également lors d'un recuit longue durée une activité photocatalytique plus importante pour le vitrage obtenu selon le procédé de l'invention.

## Revendications

1. Procédé d'obtention d'un matériau comprenant un substrat et au moins une couche mince à base d'oxyde de titane et déposée sur une première face dudit substrat, ledit procédé comprenant les étapes suivantes :
- on dépose ladite au moins une couche mince à base d'oxyde de titane, la couche à base d'oxyde de titane est une couche en oxyde de titane éventuellement dopé par un ion métallique,
- on dépose au-dessus de ladite couche mince à base d'oxyde de titane, une couche de protection temporaire inorganique à base de carbone, la couche de protection temporaire est déposée en contact direct avec la couche à base d'oxyde de titane,
- on soumet le matériau à un traitement thermique à une température supérieure à 350 °C.

2. Procédé selon la revendication 1, tel que la couche de protection temporaire est éliminée au moins partiellement, de préférence totalement, lors du traitement thermique.

3. Procédé selon l'une des revendications précédentes, tel que la couche mince à base d'oxyde de titane et la couche de protection temporaire sont déposées par pulvérisation cathodique.

4. Procédé selon l'une des revendications précédentes, dans lequel la couche de protection temporaire à base de carbone présente une épaisseur comprise entre 1 et 10 nm, de préférence entre 2 et 5 nm.

5. Procédé selon l'une des revendications précédentes, tel que la couche protection temporaire est en carbone du type graphite ou diamant.

6. Procédé selon l'une des revendications précédentes, tel que le traitement thermique est une trempe réalisé à une température d'au moins 500°C, de préférence d'au moins 600 °C.

7. Procédé selon la revendication 6, tel que le traitement thermique est réalisé pendant une durée d'au moins 30 s, de préférence d'au moins 60 s et mieux d'au moins 150 s

8. Procédé selon l'une des revendications 1 à 5, tel que le traitement thermique est un recuit réalisé à un une température comprise entre 350 °C et 550 °C pendant une durée d'au moins 1heure.

9. Procédé selon l'une des revendications précédentes, tel que l'on obtient une couche mince à base d'oxyde de titane au moins partiellement cristallisée sous forme anatase.

10. Procédé selon l'une des revendications précédentes, tel que le substrat est en verre, notamment silico-sodo-calcique.

11. Procédé selon l'une des revendications précédentes, tel que le substrat présente au moins une dimension supérieure ou égale à 1 m, voire 2 m.

12. Procédé selon l'une des revendications précédentes, tel que le matériau comprend au moins une couche barrière à base d'oxyde ou de nitrure de silicium déposée directement au contact de la première face du substrat.

## Patentansprüche

1. Verfahren zur Herstellung eines Materials, das ein Substrat und mindestens eine Dünnschicht auf Titanoxidbasis und auf einer ersten Fläche des Substrats abgeschieden umfasst, wobei das Verfahren die folgenden Schritte umfasst:
- Abscheiden der mindestens einen Dünnschicht auf Titanoxidbasis, wobei die Schicht auf Titanoxidbasis eine Schicht aus Titanoxid ist, die eventuell mit einem metallischen Ion dotiert ist,
- Abscheiden, über der Dünnschicht auf Titanoxidbasis, einer vorübergehenden anorganischen Schutzschicht auf Kohlenstoffbasis, wobei die vorübergehende Schutzschicht in direkter Berührung mit der Schicht auf Titanoxidbasis abgeschieden wird,
- Unterwerfen des Materials einer Wärmebehandlung bei einer Temperatur höher als 350 °C.

2. Verfahren nach Anspruch 1, wobei die vorübergehende Schutzschicht mindestens teilweise, bevorzugt vollständig, bei der Wärmebehandlung entfernt wird.

3. Verfahren nach einem der vorstehenden Ansprüche, wobei die Dünnschicht auf Titandioxidbasis und die vorübergehende Schutzschicht durch Sputtern abgeschieden werden.

4. Verfahren nach einem der vorstehenden Ansprüche, wobei die vorübergehende Schutzschicht auf Kohlenstoffbasis eine Stärke zwischen 1 und 10 nm, bevorzugt zwischen 2 und 5 nm umfasst.

5. Verfahren nach einem der vorstehenden Ansprüche, wobei die vorübergehende Schutzschicht aus Kohlenstoff vom Typ Graphit oder Diamant ist.

6. Verfahren nach einem der vorstehenden Ansprüche, wobei die Wärmebehandlung ein Härten ist, das bei einer Temperatur von mindestens 500 °C, bevorzugt mindestens 600 °C durchgeführt wird.

7. Verfahren nach Anspruch 6, wobei die Wärmebehandlung während einer Dauer von mindestens 30 s, bevorzugt mindestens 60 s und besser mindestens 150 s durchgeführt wird.

8. Verfahren nach einem der Ansprüche 1 bis 5, wobei die Wärmebehandlung ein Tempern ist, das bei einer Temperatur zwischen 350 °C und 550 °C während einer Dauer von mindestens 1 Stunde durchgeführt wird.

9. Verfahren nach einem der vorstehenden Ansprüche, wobei eine Dünnschicht auf Titanoxidbasis mindestens teilweise kristallisiert in Form von Anatas erhalten wird.

10. Verfahren nach einem der vorstehenden Ansprüche, wobei das Substrat aus Glas, insbesondere aus Kalk-Natron-Silikatglas ist.

11. Verfahren nach einem der vorstehenden Ansprüche, wobei das Substrat mindestens ein Abmessung größer oder gleich 1 m, ja sogar 2 m aufweist.

12. Verfahren nach einem der vorstehenden Ansprüche, wobei das Material mindestens eine direkt in Berührung mit der ersten Fläche des Substrats abgeschiedene Sperrschicht auf Siliziumoxid- oder Siliziumnitridbasis umfasst.

## Claims

1. A process for obtaining a material comprising a substrate and at least one thin layer based on titanium oxide and deposited on a first face of said substrate, said process comprising the following steps:
- said at least one thin layer based on titanium oxide is deposited, the layer based on titanium oxide is a layer made of titanium oxide optionally doped with a metal ion,
- a carbon-based inorganic temporary protective layer is deposited on top of said thin layer based on titanium oxide, the temporary protective layer is deposited in direct contact with the layer based on titanium oxide,
- the material is subjected to a heat treatment at a temperature above 350°C.

2. The process as claimed in claim 1, such that the temporary protective layer is eliminated at least partially, preferably completely, during the heat treatment.

3. The process as claimed in either of the preceding claims, such that the thin layer based on titanium oxide and the temporary protective layer are deposited by sputtering.

4. The process as claimed in one of the preceding claims, wherein the carbon-based temporary protective layer has a thickness of between 1 and 10 nm, preferably between 2 and 5 nm.

5. The process as claimed in one of the preceding claims, such that the temporary protective layer is made of carbon of graphite or diamond type.

6. The process as claimed in one of the preceding claims, such that the heat treatment is a tempering carried out at a temperature of at least 500°C, preferably of at least 600°C.

7. The process as claimed in claim 6, such that the heat treatment is carried out for a duration of at least 30 s, preferably of at least 60 s and better still of at least 150 s.

8. The process as claimed in one of claims 1 to 5, such that the heat treatment is an annealing carried out at a temperature of between 350°C and 550°C for a duration of at least 1 hour.

9. The process as claimed in one of the preceding claims, such that a thin layer based on titanium oxide that is at least partially crystallized in anatase form is obtained.

10. The process as claimed in one of the preceding claims, such that the substrate is made of glass, in particular soda-lime-silica glass.

11. The process as claimed in one of the preceding claims, such that the substrate has at least one dimension greater than or equal to 1 m, or even 2 m.

12. The process as claimed in one of the preceding claims, such that the material comprises at least one barrier layer based on silicon oxide or silicon nitride deposited directly in contact with the first face of the substrate.
